# EUROPÄISCHE PATENTSCHRIFT

(11) **EP 0 666 601 B1**
(45) Veröffentlichungstag und Bekanntmachung des Hinweises auf die Patenterteilung: **03.05.2000**
(21) Anmeldenummer: 95810021.6
(22) Anmeldetag: 12.01.1995
(51) Int. Cl.: H01L 29/744, H01L 23/367

(54) **Abschaltbares Halbleiterbauelement**
Turn-off semiconductor device
Dispositif semi-conducteur à commande d'extinction

(30) Priorität: 04.02.1994 DE 4403429
(43) Veröffentlichungstag der Anmeldung: 09.08.1995
(73) Patentinhaber: ABB (Schweiz) AG, 5401 Baden (CH)
(72) Erfinder: Jaecklin, André, Prof. Dr., CH-5400 Ennetbaden (CH); Ramezani, Ezatollah, Dr., CH-5103 Möriken (CH); Roggwiller, Peter, Dr., CH-8173 Riedt-Neerach (CH); Rüegg, Andreas, Dr., CH-5412 Gebenstorf (CH); Stockmeier, Thomas, Dr., Rancho Palos Verdes, CA 90275 (US); Streit, Peter, Dr., D-8967 Widen (CH); Waldmeyer, Jürg, Dr., CH-5605 Dottikon (CH)
(74) Vertreter: Clerc, Natalia

(56) Entgegenhaltungen:
- EP-A- 0 283 588
- EP-A- 0 325 774
- PATENT ABSTRACTS OF JAPAN vol. 009, no. 043 (E-298), 22. Februar 1985 & JP 59 184551 A (HITACHI SEISAKUSHO KK), 19. Oktober 1984

## Beschreibung

### TECHNISCHES GEBIET

Bei der Erfindung wird ausgegangen von einem abschaltbaren Halbleiterbauelement nach dem Oberbegriff des Patentanspruchs 1.

### STAND DER TECHNIK

Mit dem Oberbegriff des Patentanspruchs 1 nimmt die Erfindung auf einen Stand der Technik Bezug, wie er aus der US-A-5,248,622 bekannt ist. Dort ist ein abschaltbares, legiertes Halbleiterbauelement in der Technologie des freien Druckkontaktes angegeben, dessen Halbleiterkörper randseitig ein Silikonharz aufweist, das thermisch entlastend wirkt, wenn der Halbleiterkörper in ein Gehäuse eingebaut wird. Für nichtlegierte Leistungshalbleiter ist eine derartige thermische Randentlastung unzureichend.

Aus der EP-A2-0 387 721 ist ein abschaltbarer Thyristor bekannt, bei dem eine randseitige Abschaltelektrode zum Absaugen der in einer Basisschicht angesammelten Minoritätsladungsträger auch eine thermische Randentlastung bewirkt. Dieser 2 Gates erfordernde Thyristor ist für Leistungsmodule ungeeignet.

Die DE-OS 2 041 727 offenbart eine Halbleiterscheibe, auf der in einer Ringzone mehrere radial ausgerichtete GTO-Thyristorsegmente angeordnet sind, die randseitig keine Katodenmetallisierung aufweisen, um beim Abschalten eine gleichmäßige Stromverteilung über den gesamten Kathodenbereich durch eine randseitige Widerstandserhöhung zu erreichen.

Aus der EP-A2-0 283 588 ist ein GTO-Thyristor, entsprechend dem Oberbegriff des Anspruchs 1, bekannt, bei dem zur gleichmäßigen Ansteuerung der parallelgeschalteten Einzelelemente in einem äußeren Ring angeordnete GTO-Thyristor-Segmente einen kleineren elektrischen Widerstand zwischen Kathodenkontakt und Gatekontakt aufweisen als in einem inneren Ring. Im äußeren Ring kann ein Gateabstand zum n-Emitter von 50 µm eingestellt sein, während er beim inneren Ring 150 µm beträgt. Der elektrisch wirksame Abstand kann durch eine Isolationsschicht eingestellt werden, welche unter die jeweilige angrenzende Metallisierung von Kathode und Steuerelektrode greift. Unterschiedliche Widerstände können auch durch unterschiedlich dicke Schichten der p-Basisschicht an den Stellen, an denen sie an die Oberfläche tritt, erreicht werden. Die p-Basisschicht kann an diesen Stellen auch ein unterschiedliches Dotierungsprofil aufweisen; es kann dort auch eine stärker dotierte Zusatzschicht aufgebracht sein.

Ein Nachteil dieser Methoden besteht darin, daß die Benachteiligung der ungünstig plazierten Segmente nicht bloß von deren Lage abhängt, sondern ebenso von der Art der Ansteuerung. Je nachdem, ob diese Ansteuerung den Unterschied zwischen den Segmenten betont oder unterdrückt, ist die anordnungsmäßig eingeleitete Gegenmaßnahme ungenügend oder überkompensierend.

Abschaltbare, sogenannte GTO-Thyristoren werden als Leistungshalbleiterbauelemente insbesondere in Umrichtern großer Leistung eingesetzt. Dabei wird zur Regelung oft das Verfahren der Pulsweitenmodulation angewendet, bei welchem mit annähernd konstanter, von Ein- und Ausgangsfrequenzen unabhängiger Schaltfrequenz die GTO-Thyristoren ein- und ausgeschaltet werden. Die dabei in den Elementen anfallende elektrische Verlustleistung ist ein wichtiges Dimensionierungskriterium, da sie das Bauelement aktiv aufheizt und daher durch Kühlung abgeführt werden muß, unter Berücksichtigung der maximal zulässigen Übergangstemperatur und der thermischen Widerstände zwischen Halbleiterkörper und Kühlkörper.

Die gesamte im Halbleiterkörper anfallende elektrische Verlustleistung kann unterteilt werden in statische Verluste einerseits, welche vom mittleren Taktzyklus abhängen, und in dynamische Verluste andererseits, welche frequenzproportional sind und sich aus Ein- und Ausschaltverlusten zusammensetzen. Alle diese Verlustanteile sind temperaturabhängig. Daher wird natürlich auch die Aufheizrate selbst eine Funktion der Übergangstemperatur.

Während die Temperaturabhängigkeit der meisten Verlustkomponenten (statische, Einschalten) eher klein ist, steigen die Abschaltverluste je Puls bei höheren Temperaturen deutlich. Da gleichzeitig auch die Speicherzeit zunimmt, welche die Stromverteilung während der Abschaltphase ungünstig beeinflußt, kann eine thermische Instabilität entstehen, bei welcher ein Teil der Elementfläche immer stärker aufgeheizt wird und schließlich die zulässige Maximaltemperatur übersteigt, ohne daß dabei das Element als Ganzes die thermischen Grenzdaten erreicht.

Zum einschlägigen Stand der Technik wird noch auf die EP-B1-0 200 863 verwiesen, aus der ebenfalls ein Halbleiterbauelement mit GTO-Thyristor- und Diodenstruktur bekannt ist. Die Diodenstruktur ist am Außenrand des scheibenförmigen Halbleiters in einem Abstand von ≤ 1 mm kreisförmig um ringförmig angeordnete GTO-Thyristorsegmente angebracht und antiparallel zum GTO-Thyristor geschaltet. Durch Einbau von Schwermetallatomen, wie Gold oder Platin, in das Siliziumgrundmaterial des Halbleiterbauelements oder durch Elektronen- oder Gammabestrahlung ist die Ladungsträgerlebensdauer in der Diode kürzer eingestellt als im Thyristor. Zwischen der Diode und den GTO-Steuerelektrodensegmenten ist ein Widerstand bzw. eine kreisförmige Schutzzone mit einer elektrisch isolierenden Passivierungsschicht vorgesehen, welche die Thyristor- und Diodenbereiche voneinander entkoppelt, so daß nur wenig Ladungsträger in die jeweils anderen Bereiche überwechseln können.

### DARSTELLUNG DER ERFINDUNG

Die Erfindung, wie sie im Patentanspruch 1 definiert ist, löst die Aufgabe, ein abschaltbares Halbleiterbauelement der eingangs genannten Art derart weiterzuentwickeln, daß die thermische Benachteiligung gewisser Bereiche seines Halbleiterkörpers, speziell seines Randes, vermindert wird.

Ein Vorteil der Erfindung besteht darin, daß sich unvermeidbare kleine elektrische Ungleichheiten erst bei sehr großen Strömen negativ auswirken können. Dies wird vor allem dadurch erreicht, daß im Randbereich die je Segment verfügbare mittlere Kühlleistung durch geeignete Maßnahmen erhöht wird, möglichst ohne daß dadurch die Auflagefläche der GTO-Elemente im Randbereich weiter abnimmt und damit die Empfindlichkeit auf eine inhomogene Druckverteilung noch erhöht wird.

Der Erfindung liegt die Überlegung zugrunde, daß letztlich eine thermische Überhitzung dann eintritt und die GTO-Elementfunktion gefährdet, wenn eine bereits entstandene lokale Erwärmung nicht mehr durch erhöhte Kühlleistung wettgemacht werden kann. Diese erhöhte Kühlleistung hat mit den erhöhten Temperaturgradienten in der Nähe der überhitzten Stelle zu tun und hängt von der Größe dieser Stelle ab. Analysiert man eine normale Scheibenzelle bezüglich dieser Zusatz-Kühlleistung, so wird klar, daß der GTO-Elementrand eine thermische Schwachstelle darstellt, denn hier kann ein lateraler Wärmeausgleich praktisch nur nach innen und nicht in alle Richtungen erfolgen.

Bei Scheibenzellen bildet sich nach mehrmaliger, nicht perfekt planer Einspannung meist durch leichte Deformation von Gehäuse und Metallisierung eine Druckinhomogenität dahingehend aus, daß Teile des Randes weniger spezifischen Anpreßdruck haben und damit weniger Kühlung erfahren. Durch größere thermische Widerstände an den trockenen Übergängen hat der GTO-Elementrand auch bei sonst gleichmäßig verteilten Element-Inhomogenitäten eine deutlich stärkere Tendenz zu einer vorzeitigen thermischen Überhitzung. Aufgrund der praktischen Erfahrungen ist diese thermische Benachteiligung des Randes bei großen GTOs deutlich höher zu gewichten als die bereits mehrfach diskutierten Inhomogenitäten aufgrund der Anordnung des Anschlusses der Steuerelektrode.

Ein weiterer Vorteil gemäß einer vorteilhaften Ausgestaltung der Erfindung besteht darin, daß die Zündströme in einem Temperaturbereich von - 40 °C bis 125 °C geringere Unterschiede aufweisen und somit ein präziseres Zünden möglich wird.

### KURZE BESCHREIBUNG DER ZEICHNUNGEN

Die Erfindung wird nachstehend anhand von Ausführungsbeispielen erläutert. Es zeigen:
- Fig. 1: einen Querschnitt durch einen Teil eines abschaltbaren Halbleiterbauelementes mit einem GTO-Thyristor-Segment und einem Kühlsegment,
- Fig. 2a - 2c: sektorartige Ausschnitte eines Halbleiterbauelementes in Draufsicht mit randseitig unterschiedlich angeordneten GTO-Thyristor-Segmenten und Kühlsegmenten,
- Fig. 3: ein Schaltbild des abschaltbaren Halbleiterbauelementes mit einer Zündstablisierungsdiode und
- Fig. 4: einen Querschnitt durch einen Teil eines abschaltbaren Halbleiterbauelementes gemäß Fig. 1 mit einem zusätzlichen Segment für die Zündstablisierungsdiode gemäß Fig. 3.

### WEGE ZUR AUSFÜHRUNG DER ERFINDUNG

In den Figuren sind gleiche Teile mit gleichen Bezugszeichen gekennzeichnet.

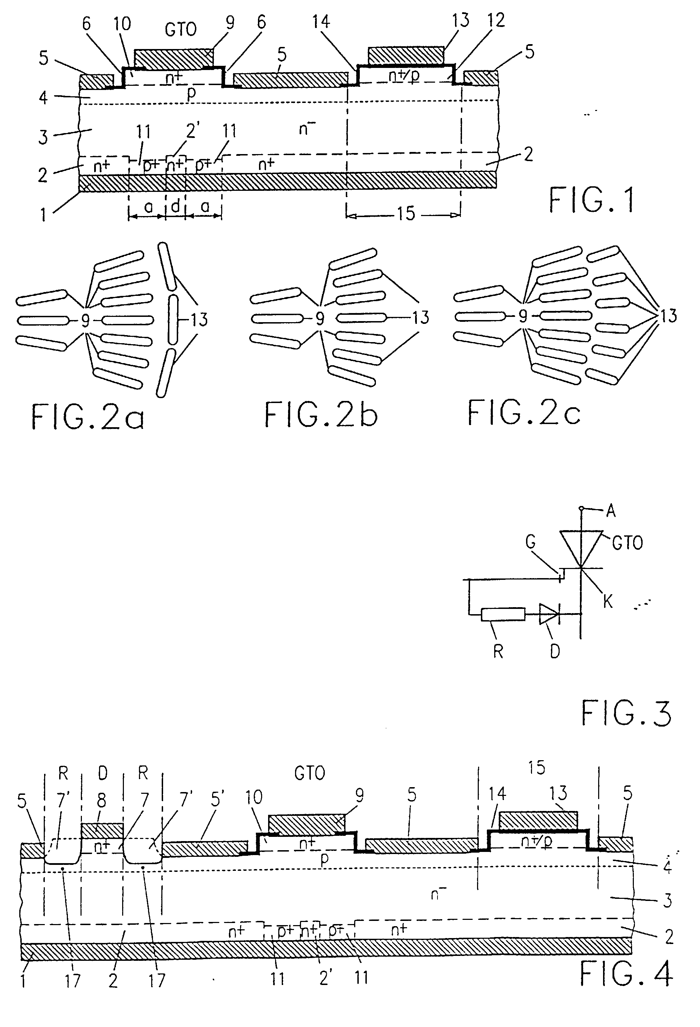

Fig. 1 zeigt ausschnittsweise einen Querschnitt durch ein scheibenförmiges Halbleiterbauelement mit lateral benachbarten Bereichen eines GTO-Thyristor-Segmentes (GTO) und eines Kühlsegmentes (15), das randseitig bezüglich des GTO-Thyristor-Segmentes (GTO) angeordnet ist. An der Unterseite dieses Halbleiterbauelementes ist eine Anodenmetallisierung (1) z. B. aus Aluminium vorgesehen, welche als Anode (A), vgl. Fig. 4, eine 1. Hauptelektrode des abschaltbaren Halbleiterbauelementes darstellt. An der Oberseite dieses Halbleiterbauelementes ist eine GTO-Kathodenmetallisierung (9) vorgesehen, die elektrisch über eine nicht dargestellte Molybdän-Druckplatte sowie eventuellen weiteren Zwischenschichten mit einer Kühlsegmentmetallisierung (13) verbunden ist und als Kathode (K) eine 2. Hauptelektrode des abschaltbaren Halbleiterbauelementes darstellt. Im Betrieb ist die kathodenseitige Kontaktplatte mit einem nicht dargestellten Kühlkörper zum Abführen der Verlustwärme des Halbleiterkörpers wärmeleitend verbunden. Mit (5) ist eine Steuerelektrodenmetallisierung bezeichnet, welche die GTO-Kathodenmetallisierung (9) sowie die Kühlsegmentmetallisierung (13) mit einem vorgebbaren Widerstandsabstand umgibt und tiefer gelegen ist als diese, so daß der elektrische Anschluß unterhalb der nicht dargestellten Druckplatte lateral zu einer nicht dargestellten zentralen oder ringförmigen Öffnung und von dort über ein nicht dargestelltes separates Kontaktstück isoliert seitlich nach außen weggeführt ist.

Das Halbleiterbauelement besteht hauptsächlich aus einer relativ dicken, niedrigdotierten, n-leitenden n⁻-Basisschicht (3), auf welcher kathodenseitig eine p-leitende p-Basisschicht (4) aufgebracht ist. Auf diese p-Basisschicht (4) ist im Kathodenbereich des GTO-Thyristor-Segmentes (GTO) eine hochdotierte, n-leitende n⁺-GTO-Emitterschicht (10) aufgebracht, welche lateral etwas größer ist als die GTO-Kathodenmetallisierung (9). Mit etwa gleicher lateraler Erstreckung wie die n⁺-GTO-Emitterschicht (10) ist anodenseitig von der n⁻-Basisschicht (3) und unterhalb der n⁺-GTO-Emitterschicht (10) eine hochdotierte, p-leitende p⁺-Anoden-Emitterschicht (11) aufgebracht. In geringem lateralem Abstand zu dieser p⁺-Anoden-Emitterschicht (11) ist anodenseitig im übrigen Lateralbereich auf die n⁻-Basisschicht (3) eine hochdotierte, n-leitende n⁺-Kurzschlußschicht (2) und (2') aufgebracht, welche die p⁺-Anoden-Emitterschicht (11) kurzschließt. Diese kann unterschiedlich strukturiert sein, z. B. wie in Fig. 1 dargestellt, mit einem schmalen Streifen der n⁺-Kurzschlußschicht (2') im Zentrum der p⁺-Anoden-Emitterschicht (11) oder ohne einen derartigen Streifen (2'). Diese n⁺-Kurzschlußschicht (2') hat eine Breite (d), die vorzugsweise kleiner ist als eine Breite (a) der p⁺-Anoden-Emitterschicht (11). Durch eine Variation dieser Breite (a) kann der Zündzeitpunkt des GTO-Thyristor-Segmentes (GTO) beeinflußt werden.

Eine elektrische Isolierschicht (6) bedeckt den seitlichen Rand der n⁺-GTO-Emitterschicht (10) und den Zwischenraum zwischen der GTO-Kathodenmetallisierung (9) und der Steuerelektrodenmetallisierung (5), wobei die beiden Metallisierungen (9, 5) den Randbereich der Isolierschicht (6) bedecken. Eine elektrische Isolierschicht (14) bedeckt die obere Fläche und den seitlichen Rand einer Kühlsegment-Grenzschicht (12) und den Zwischenraum zwischen der Kühlsegmentmetallisierung (13) und der Steuerelektrodenmetallisierung (5), welche den Randbereich der elektrischen Isolierschicht (14) bedeckt. Die Kühlsegment-Grenzschicht (12) kann eine n⁺-GTO-Emitterschicht (10) oder eine p-Basisschicht (4) sein.

Die Fig. 2a - 2c zeigen in Draufsicht ausschnittsweise unterschiedliche sektorförmige Anordnungen von GTO-Thyristor-Segmenten (GTO) bzw. GTO-Kathodenmetallisierungen (9) und Kühlsegmentmetallisierungen (13). Bei Fig. 2a sind die Ausrichtungen der länglichen, randseitigen Kühlsegmentmetallisierungen (13) im wesentlichen senkrecht zu den Ausrichtungen der länglichen GTO-Kathodenmetallisierungen (9) orientiert. Bei Fig. 2b sind in der äußeren Ringzone Kühlsegmentmetallisierungen (13) alternierend zu GTO-Kathodenmetallisierungen (9), im wesentlichen radial ausgerichtet wie die GTO-Kathodenmetallisierungen (9). Bei Fig. 2c sind die Kühlsegmentmetallisierungen (13), im Unterschied zu denen von Fig. 2b, zum Außenrand verschoben bzw. zu den GTO-Kathodenmetallisierungen (9) versetzt auf Lücke angeordnet. Die randseitigen Kühlsegmentmetallisierungen (13) bewirken bei diesen Anordnungen im Betrieb eine zusätzliche Kühlung.

Fig. 3 zeigt in einem Schaltbild einen GTO-Thyristor (GTO) mit Anode (A), Kathode (K) und Steuerelektrode (G), welche über eine Reihenschaltung eines Widerstandes (R) und einer Zündstabilisierungsdiode bzw. Diode (D) mit der Kathode (K) verbunden ist. Der Widerstand (R) hat einen Widerstandswert im Bereich von 10 Ω - 500 Ω, vorzugsweise im Bereich von 50 Ω - 200 Ω.

Fig. 4 zeigt, zusätzlich zu dem in Fig. 1 gezeigten Ausführungsbeispiel der Erfindung, ausschnittsweise einen Querschnitt durch ein scheibenförmiges Halbleiterbauelement mit einem zu dem GTO-Thyristor-Segment (GTO) lateral benachbarten Bereich für die Diode (D) und einen ringförmig um die Diode (D) angeordneten Widerstand (R). Dabei ist ein 3schichtiger n⁺n⁻p-Bereich der Steuerelektrodenmetallisierung (5) des GTO-Thyristor-Segmentes (GTO) von dessen 4schichtigem p⁺n⁻pn⁺-Bereich lateral durch die Bereiche des Widerstandes (R) und der Diode (D) getrennt.

Die Steuerelektrode (G) ist über Steuerelektrodenmetallisierungen (5, 5') bzw. über eine Steuerhauptelektrode (5) und eine Steuerhilfselektrode (5') direkt mit der p-Basisschicht (4) verbunden. Im Bereich der Diode (D) ist die je nach Bedarf kleinflächige Diode-Kathodenmetallisierung (8) über eine n⁺-Dioden-Emitterschicht (7) mit der p-Basisschicht (4) verbunden.

Grundsätzlich kann die Diode (D) wie ein konventionelles GTO-Thyristor-Segment (GTO) ausgebildet werden. In diesem Fall ergibt sich in der Mesastruktur des Siliziums eine durchgehende n⁺-Dioden-Emitterschicht (7), die sich auch über ein gestrichelt angedeutetes, lateral angrenzendes Widerstandsgebiet (7') erstreckt. Der Stromfluß zur Steuerhauptelektrode (5) und zur Steuerhilfselektrode (5') des Kontaktes der Steuerelektrode (G) ist symmetrisch. Mit dieser Struktur resultiert ein sehr geringer Reihenwiderstand (R), der für praktische Anwendungen zu einem zu großen Zündstrombedarf führen könnte.

Zur gezielten Dimensionierung dieses Widerstandes (R) kann deshalb die laterale Ausdehnung der n⁺-Dioden-Emitterschicht (7) begrenzt werden. Das verbleibende, symmetrisch angeordnete Widerstandsgebiet (7') enthält nur die p-Dotierung und wirkt als Teil des Widerstandes (R). Da dieser Widerstand (R) meist relativ gering ist, wird dadurch eine gute Stabilisierung gewährleistet, insbesondere bei hohen Temperaturen.

Anstelle des p-dotierten Widerstandsgebietes (7') kann eine weitere Erhöhung des Widerstandes (R) durch eine Verringerung der Schichtdicke des lateralen Bereiches der p-Basisschicht (4) z. B. durch Ätzen bis zu einer bestimmten Tiefe erreicht werden. Dieses Widerstandsgebiet ist mit (17) bezeichnet. Die geringe Leitfähigkeit der verbleibenden p-Schicht im Bereich des Widerstandsgebietes (17) führt zu einem großen Widerstand (R).

In allen praktischen Fällen wird eine im wesentlichen gleiche geometrische Dimensionierung des Widerstandes (R) entlang des gesamten Randes der Diode (D) angestrebt.

Die Diodenstrecke auf der kathodenseitigen Oberfläche des Halbleiterbauelementes leistet zur eigentlichen Stromführung des GTO-Thyristor-Segmentes (GTO) keinen Beitrag. Elektrisch gesehen kann die Zündschwelle des Gesamtsystems dadurch erheblich heraufgesetzt werden. Dieser Effekt ist praktisch unabhängig von der lokalen Anordnung und Entfernung der einzelnen Bereiche; er wirkt, auch bei hybrider Anordnung, solange die Streuinduktivität klein ist.

Da die Wirkung der Diode (D) proportional zu deren Fläche steigt, ist deren geometrische Größe wichtig.

Eine höhere Ladungsträger-Lebensdauer im Diodenbereich (D) im Vergleich zum GTO-Thyristor-Segmentbereich (GTO) steigert die Wirksamkeit. Falls Rekombinationszentren gewählt werden, die nur oberhalb einer kritischen Temperatur im Bereich zwischen - 40 °C und 125 °C eine Temperaturabhängigkeit aufweisen, läßt sich ein großer Leckstrom bei tiefen Temperaturen zusätzlich reduzieren.

Da der Diodenteil (D) nur einen relativ geringen Strom führt, genügt meist eine kleinflächige Diodenmetallisierung (8). Für den Bereich der n⁺-Dioden-Emitterschicht (7) können deshalb möglicherweise nicht genutzte Flächenteile der Kathodenseite des Halbleiterbauelements verwendet werden.

Bei Vorhandensein von Unterschieden in der Ladungsträger-Lebensdauer in der p-Basisschicht (4) ergibt sich eine starke Umverteilung der lokalen Ströme. Das GTO-Thyristor-Segment (GTO) mit der kürzesten Ladungsträger-Lebensdauer übernimmt kurz vor Erreichen der Zündschwelle annähernd den ganzen Löcherstrom. Daraus folgt, daß geringfügige technologische Unterschiede zu einer starken Veränderung des totalen Zündstromes führen können.

Es versteht sich, daß für die Elektrodenmetallisierungen (1, 5, 5', 8, 9, 13) übliche Metalle oder Metallegierungen verwendet werden können. Vorzugsweise wird Aluminium verwandt. Das Halbleiterbauelement kann kreisrunde oder andere Gestalt aufweisen. Wichtig ist, daß insbesondere die randseitigen GTO-Thyristor-Segmente (GTO) thermisch entlastet werden.

Für die Stabilisierung der Zündschwelle und die Reduzierung von deren Temperaturabhängigkeit ist es vorteilhaft, die Steuerelektrode (G) des GTO-Thyristor-Segments (GTO) über eine Diode (D) mit dessen Kathode (K) elektrisch zu verbinden, wobei die Kathoden dieser beiden Bauelemente kurzgeschlossen sind.

Grundsätzlich kann die Diode (D) auch in hybrider Form stabilisierend wirken. Sie kann als n⁺p-Diode oder als Schottky-Diode ausgebildet sein. Der Strom durch die Diode (D) fließt lateral von den Steuerelektrodenmetallisierungen (5, 5') zur Diodenmetallisierung (8). Ein parasitärer Strom von der Anode (A) wird durch die n⁺-Emitterschicht (2) verhindert.

Zusätzlich kann das Halbeiterbauelement mindestens eine in den Figuren nicht dargestellte Diode antiparallel zu dem mindestens einen GTO-Thyristor-Segment (GTO) aufweisen, wie es für rückwärtsleitende Thyristoren üblich ist.

### BEZEICHNUNGSLISTE

- 1: Anodenmetallisierung, 1. Hauptelektrode
- 2: n⁺-Kurzschlußschicht
- 2': n⁺-Kurzschlußschicht im Zentrum von 11
- 3: n⁻-Basisschicht
- 4: p-Basisschicht
- 5: Steuerelektrodenmetallisierung,
Steuerhauptelektrode
- 5': Steuerelektrodenmetallisierung,
Steuerhilfselektrode
- 6, 14: elektrische Isolierschichten
- 7: n⁺-Dioden-Emitterschicht
- 7', 17: Widerstandsgebiete, Widerstandszonen,
Widerstandspfade
- 8: Diodenmetallisierung
- 9: GTO-Kathodenmetallisierung, 2. Hauptelektrode
- 10: n⁺-GTO-Emitterschicht
- 11: p⁺-GTO-Emitterschicht
- 12: Kühlsegment-Grenzschicht
- 13: Kühlsegmentmetallisierung
- 15: Kühlsegment
- a: Breite von 11
- A: Anode
- d: Breite von 2'
- D: Diode, Zündstabilisierungsdiode
- G: Steuerelektrode
- GTO: GTO-Thyristor, GTO-Thyristor-Segment
- K: Kathode
- R: Widerstand
- τ₁, τ₂: Ladungsträger-Lebensdauern

## Patentansprüche

1. Abschaltbares Halbleiterbauelement mit einem scheibenförmigen Halbleiterkörper
a) mit mindestens einem GTO-Thyristor-Segment oder GTO-Thyristor (GTO), der mindestens ein Anodensegment oder eine Anode (A), mindestens ein Kathodensegment oder eine Kathode (K) und mindestens ein Steuerelektrodensegment oder eine Steuerelektrode (G) aufweist,
dadurch gekennzeichnet,
b) daß im randseitigen Bereich des Halbleiterkörpers mindestens ein Kühlsegment (15) mit einer Kühlsegmentmetallisierung (13) angeordnet ist und
c) daß diese Kühlsegmentmetallisierung (13) durch eine elektrische Isolierschicht (14) von dem Anodensegment beziehungsweise der Anode elektrisch isoliert ist.

2. Abschaltbares Halbleiterbauelement nach Anspruch 1,
dadurch gekennzeichnet,
a) daß mindestens ein Kühlsegment (15) von einer GTO-Kathodenmetallisierung (9) des GTO-Thyristor-Segments (GTO) durch ein Segment einer Steuerelektrodenmetallisierung (5) der Steuerelektrode (G) getrennt ist,
b) insbesondere, daß das Kühlsegment (15) randseitig zur GTO-Kathodenmetallisierung (9) angeordnet ist.

3. Abschaltbares Halbleiterbauelement nach Anspruch 1 oder 2, dadurch gekennzeichnet,
a) daß der Halbleiterkörper im Bereich des mindestens einen Kühlsegments (15) eine Kühlsegment-Grenzschicht (12) aufweist,
b) daß die elektrische Isolierschicht (14) zwischen dieser Kühlsegment-Grenzschicht (12) und der Kühlsegmentmetallisierung (13) angeordnet ist und
c) daß die Kühlsegment-Grenzschicht (12) eine n⁺-GTO-Emitterschicht (10) oder
d) eine p-Basisschicht (4) ist.

4. Abschaltbares Halbleiterbauelement nach einem der vorhergehenden Ansprüche, dadurch gekennzeichnet,
a) daß die mindestens eine Steuerelektrode (G) über mindestens eine Zündstabilisierungsdiode (D) mit der mindestens einen Kathode (K) des GTO-Thyristor-Segments oder GTO-Thyristors (GTO) in Wirkverbindung steht,
b) mit Durchlaßrichtung der Zündstabilisierungsdiode (D) von der Steuerelektrode (G) zur Kathode (K) des GTO-Thyristors (GTO).

5. Abschaltbares Halbleiterbauelement nach Anspruch 4 dadurch gekennzeichnet,
a) daß eine n⁺-Dioden-Emitterschicht (7) mindestens einer Zündstabilisierungsdiode (D) auf der Kathodenoberfläche sowie
b) eine n⁺-Emitterschicht (2) auf der direkt gegenüberliegenden Fläche der Anode (A) des Halbleiterbauelementes angeordnet ist,
c) daß mehrere GTO-Thyristor-Segmente (GTO) in einem GTO-Bereich und die mindestens eine Zündstabilisierungsdiode (D) in einem Diodenbereich angeordnet sind,
d) daß der Diodenbereich von dem GTO-Bereich durch mindestens einen Widerstandspfad (7', 17) getrennt ist,
e) daß der Widerstandspfad (7', 17) ein Teil einer p-Basisschicht (4) ist, welche dem mindestens einen GTO-Thyristor-Segment (GTO) und der mindestens einen Zündstabilisierungsdiode (D) gemeinsam ist,

## Claims

1. Gate-turn-off semiconductor component with a disc-shaped semiconductor body
a) having at least one GTO thyristor segment or GTO thyristor (GTO) which exhibits at least one anode segment or an anode (A), at least one cathode segment or a cathode (K) and at least one gate electrode segment or a gate electrode (G),
characterized
b) in that at least one cooling segment (15) with a cooling segment metallization (13) is arranged in the edge area of the semiconductor body and
c) in that this cooling segment metallization (13) is electrically insulated from the anode segment or the anode by an electrical insulation layer (14).

2. Gate-turn-off semiconductor component according to Claim 1, characterized
a) in that at least one cooling segment (15) is isolated from a GTO cathode metallization (9) of the GTO thyristor segment (GTO) by a segment of a gate electrode metallization (5) of the gate electrode (G),
b) in particular, in that the cooling segment (15) is arranged at the edge with respect to the GTO cathode metallization (9).

3. Gate-turn-off semiconductor component according to Claim 1 or 2, characterized
a) in that the semiconductor body exhibits a cooling segment boundary layer (12) in the area of the at least one cooling segment (15),
b) in that the electrical insulation layer (14) is arranged between this cooling segment boundary layer (12) and the cooling segment metallization (13), and
c) in that the cooling segment boundary layer (12) is an n⁺-type GTO emitter layer (10) or
d) a p-type base layer (4).

4. Gate-turn-off semiconductor component according to one of the preceding claims, characterized
a) in that the at least one gate electrode (G) is effectively connected to the at least one cathode (K) of the GTO thyristor segment or GTO thyristor (GTO) via at least one trigger stabilization diode (D),
b) the forward direction of the trigger stabilization diode (D) being from the gate electrode (G) to the cathode (K) of the GTO thyristor (GTO).

5. Gate-turn-off semiconductor component according to Claim 4, characterized
a) in that an n⁺-type diode-emitter layer (7) of at least one trigger stabilization diode (D) is arranged on the cathode surface and
b) an n⁺-type emitter layer (2) is arranged on the directly opposite surface of the anode (A) of the semiconductor component,
c) in that several GTO thyristor segments (GTO) are arranged in a GTO area and the at least one trigger stabilization diode (D) is arranged in a diode area,
d) in that the diode area is isolated from the GTO area by at least one resistance path (7', 17),
e) in that the resistance path (7', 17) is a part of a p-type base layer (4) which is common to the at least one GTO thyristor segment (GTO) and the at least one trigger stabilization diode (D).

## Revendications

1. Dispositif semi-conducteur à commande d'extinction avec un corps semi-conducteur en forme de disque,
a) avec au moins un segment de thyristor interruptible ou un thyristor interruptible (GTO), qui présente au moins un segment d'anode ou une anode (A), au moins un segment de cathode ou une cathode (K) et au moins un segment d'électrode de commande ou une électrode de commande (G),
caractérisé en ce que
b) dans la région de bord du corps semi-conducteur est disposé au moins un segment de refroidissement (15) avec une métallisation de segment de refroidissement (13), et en ce que
c) cette métallisation de segment de refroidissement (13) est électriquement isolée du segment d'anode, respectivement de l'anode, par une couche isolante électrique (14).

2. Dispositif semi-conducteur à commande d'extinction suivant la revendication 1, caractérisé en ce que
a) au moins un segment de refroidissement (15) est séparé d'une métallisation de cathode GTO (9) du segment de thyristor interruptible (GTO) par un segment d'une métallisation d'électrode de commande (5) de l'électrode de commande (G), et en ce que
b) en particulier le segment de refroidissement (15) est disposé du côté du bord par rapport à la métallisation de cathode GTO (9).

3. Dispositif semi-conducteur à commande d'extinction suivant la revendication 1 ou 2, caractérisé en ce que
a) le corps semi-conducteur présente une couche limite du segment de refroidissement (12) dans la région du au moins un segment de refroidissement (15), en ce que
b) la couche isolante électrique (14) est disposée entre cette couche limite du segment de refroidissement (12) et la métallisation de segment de refroidissement (13), et en ce que
c) la couche limite du segment de refroidissement (12) est une couche émetteur GTO n⁺ (10) ou
d) une couche de base p (4).

4. Dispositif semi-conducteur à commande d'extinction suivant l'une quelconque des revendications précédentes, caractérisé en ce que
a) la au moins une électrode de commande (G) est en liaison active avec la au moins une cathode (K) du segment de thyristor interruptible ou du thyristor interruptible (GTO) par au moins une diode de stabilisation de l'amorçage (D),
b) avec une direction de traversée de la diode de stabilisation de l'amorçage (D) allant de l'électrode de commande (G) vers la cathode (K) du thyristor interruptible (GTO).

5. Dispositif semi-conducteur suivant la revendication 4, caractérisé en ce que
a) une couche émetteur de diode n⁺ (7) d'au moins une diode de stabilisation de l'amorçage (D) est disposée sur la surface cathodique, ainsi que
b) une couche émetteur n⁺ (2) est disposée sur la face directement opposée de l'anode (A) du dispositif semi-conducteur, en ce que
c) plusieurs segments de thyristor interruptible (GTO) sont disposés dans une zone GTO et la au moins une diode de stabilisation de l'amorçage (D) est disposée dans une zone de diode, en ce que
d) la zone de diode -est séparée de la zone GTO par au moins un chemin de résistance (7', 17), et en ce que
e) le chemin de résistance (7', 17) est une partie d'une couche de base p (4), qui est commune au au moins un segment de thyristor interruptible (GTO) et à la au moins une diode de stabilisation de l'amorçage (D).
